(19) **Europäisches Patentamt / European Patent Office / Office européen des brevets**

(11) **EP 1 929 424 B1**

(12) **EUROPÄISCHE PATENTSCHRIFT**

(45) Veröffentlichungstag und Bekanntmachung des Hinweises auf die Patenterteilung:
**23.11.2011 Patentblatt 2011/47**

(21) Anmeldenummer: **06792066.0**

(22) Anmeldetag: **14.09.2006**

(51) Int Cl.:
*G06K 7/00* (2006.01)  *H04B 5/00* (2006.01)

(86) Internationale Anmeldenummer:
**PCT/EP2006/008971**

(87) Internationale Veröffentlichungsnummer:
**WO 2007/031318 (22.03.2007 Gazette 2007/12)**

(54) **MIT EINEM TRANSPONDER BETÄTIGBARE SCHALTVORRICHTUNG**

TRANSPONDER ACTUATABLE SWITCHING DEVICE

DISPOSITIF DE COMMUTATION ACTIONNABLE AU MOYEN D'UN TRANSPONDEUR

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **16.09.2005 DE 102005044438**

(43) Veröffentlichungstag der Anmeldung:
**11.06.2008 Patentblatt 2008/24**

(73) Patentinhaber: **Giesecke & Devrient GmbH 81677 München (DE)**

(72) Erfinder: **FINKENZELLER, Klaus 85774 Unterföhring (DE)**

(56) Entgegenhaltungen:
**EP-A2- 1 538 558  WO-A-03/069538**
**WO-A-2005/013506  US-A- 4 546 241**
**US-B1- 6 703 921**

**Beschreibung**

Die vorliegende Erfindung betrifft eine Schaltvorrichtung zur Erzeugung eines Schaltsignals, welche sich gleichermaßen zur Integration in ein Transponder-Lesegerät wie zur nachträglichen Ausrüstung eines Transponder-Lesegeräts eignet. Desweiteren betrifft die Erfindung ein Lesegerät mit einer solchen Schaltvorrichtung sowie ein Verfahren zur Kommunikation zwischen einem Lesegerät und einem Transponder.

In den Standards ISO/IEC 14443 und ISO/IEC 15693 wird ein Verfahren beschrieben, wie ein Transponder-Lesegerät mit einem Transponder eines anderen Geräts (kontaktlose Chipkarte/ RFID Transponder) eine Datenverbindung herstellen kann. Hierzu sendet das Lesegerät solange ein Suchsignal mit hoher Feldstärke (z.B.1,5 - 7,5 A/m gemäß ISO/IEC 14443) periodisch aus, bis ein mit Transponder ausgestattetes Gerät in den Ansprechbereich des Lesegeräts gelangt, mit Energie aus dem Feld des Lesegerätes versorgt wird und eine Antwort an das Lesegerät sendet. Dies hat jedoch für Lesegeräte mit beschränkten Energieressourcen, besonders für batteriebetriebene Geräte, eine Verringerung der möglichen Betriebsdauer zufolge.

Um die Betriebsdauer eines Lesegeräts zu erhöhen, beschreibt die US 6,150,948 ein RFID-Lesegerät, welches mittels eines energiesparsamen Detektors nach Transpondern in der Umgebung sucht. Beispielsweise ist dieser Detektor ein auf Infrarotbasis arbeitender Detektor. Das RFID-Lesegerät selbst wird erst aktiviert, wenn ein Transponder in der Nähe des Lesegeräts detektiert wird.

Aus der WO 03/069538 A1 ist eine mittels eines Transponders aktivierbare Schaltvorrichtung für ein Lesegerät bekannt, die, solange ein Schaltvorgang nicht ausgelöst wird, nahezu leistungslos betrieben werden kann. Das zu aktivierende Lesegerät verfügt hierzu über eine Spule, die Teil eines Schwingkreises ist, der im Erkennungsbetrieb als im wesentlichen unbelasteter reiner Schwingkreis betrieben wird. Die im Schwingkreis stehende Resonanzfrequenz wird dabei von einem Frequenzbeobachter überwacht. Wird ein Transponder mit einer Transponderspule der Erkennungsspule angenähert, ändert sich die Resonanzfrequenz des Schwingkreises. Dies wird von dem Frequenzbeobachter erkannt, der daraufhin ein Schaltsignal erzeugt, welches das zu aktivierende Lesegerät einschaltet. Dadurch wird es möglich, einen Transponder in der Nähe der Spule auch ohne (nennenswerte) Sendeleistung zu erkennen, da die Feldstärke des während des - ggf. periodischen - Meßvorganges ausgesendeten Suchsignales nicht mehr zur Energieversorgung eines Transponders eingesetzt wird.

Auch die WO 2005/013506 A1 beschreibt eine Mess- und Schalteinrichtung zum Messen der Beeinflussung einer Sendeantenne eines RFID-Lesegeräts durch einen sich nähernden Transponder. Insbesondere beschreibt die WO 2005/013506 A1 im Detail die Abläufe in einem Lesegerät zur Detektion eines Transponders ohne Aussendung von Energie zur Energieversorgung dieses Transponders. Ein wesentlicher Bestandteil der WO 2005/013506 A1 ist dabei eine Messeinrichtung zur Messung der elektrischen Eigenschaften der Sendeantenne des Lesegeräts, wobei die Schaltung der Messeinrichtung zum Beispiel als PLL-Schaltung ausgebildet sein kann. PLL steht für "Phase Locked Loop" und bedeutet, daß ein Signal mit einer Frequenz relativ zu einem Signal mit einer Bezugsfrequenz so genau eingestellt wird, daß die Phasenbeziehung zwischen den Signalen permanent eingestellt wird. Ein Nachteil der beschriebenen PLL-Schaltung besteht jedoch darin, daß diese die Antennenspule der Lesegerätantenne als frequenzbestimmendes Bauteil eines Oszillators verwendet. Die PLL-Schaltung muss also direkt mit der Antennenspule verschaltet werden. Bei vielen Lesegeräten wird die Leserantenne jedoch mit einer Anpaßschaltung auf eine Impedanz von 50 Ω angepasst und über eine Koaxialkabelverbindung, abgesetzt von der Elektronik des Lesegeräts, installiert. Bei einer solchen Anordnung kann die beschriebene PLL-Schaltung nur schwierig oder überhaupt nicht realisiert werden.

Aus der US 4,546,241 A, das den Oberbegriff des Anspruchs 1 bildet, ist ein aus einem Leser und einem Transponder in Form einer Karte bestehendes kontaktlos arbeitendes Erkennungssystem bekannt, das eine Lastmodulation durch einen angekoppelten Transponder erkennt. Der Leser weist eine Meßbrücke auf, deren einer Brückenzweig die Leserantenne beinhaltet. Durch die von dem Transponder bewirkte Lastmodulation erfolgt eine Impedanzveränderung in der Leserantenne, die zu einer Verstimmung der Meßbrücke führt. Die Verstimmung wird herangezogen, um die Modulation zu detektieren und damit ein Datensignal von dem Transponder an den Leser zu übertragen. Die Meßbrücke dient dabei dazu, die Trägerfrequenz der Lastmodulation so weit zu entfernen, daß das aufmodulierte Datensignal gut erkennbar wird. Eine vollkommen restlose Entfernung ist dabei nicht erforderlich. Für den Abgleich zwischen den Brückenzweigen genügt eine näherungsweise Übereinstimmung. Eine exakte Abstimmung ist weder erforderlich noch sinnvoll, weil die von einem Transponder bewirkte Impedanzveränderung von dessen Ausführung und vom Abstand zwischen Transponder und Leser abhängt.

Aus der EP 1 538 558 A2 ist ferner ein Vorschlag bekannt, der sich mit dem Problem der durch Fertigungstoleranzen bedingten Streuung der Eingangskapazität eines Transponders in Gestalt einer RFID-IC-Karte befaßt. Die Streuung beeinträchtigt die Effizienz der Energie- und Datenübertragung. Vorgeschlagen wird deshalb, in einem Transponder parallel zur Antennenspule oder in Reihe mit der Eingangskapazität des integrierten Schaltkreises eine definierte Kapazität zu schalten, die es erlaubt den Einfluss einer schwankenden Eingangskapazität klein zu halten. Auf zur Kommunikation mit dem Transponder geeignete Lesegeräte geht die Schrift nicht ein. Es ist Aufgabe der vorliegenden Erfindung, eine mit einem Transponder betätigbare Schaltvorrichtung für ein zu aktivierendes Transponder-Lesegerät anzugeben, die auf Seiten des zu aktivierenden Lesegeräts einen möglichst geringen Energieverbrauch hat und des weiteren besonders einfach schaltungstechnisch zu realisieren ist.

Diese Aufgabe wird durch ein Schaltvorrichtung, ein damit ausgerüstetes Lesegerät und ein Verfahren gemäß den unabhängigen Ansprüchen gelöst. In davon abhängigen Ansprüchen sind vorteilhafte Ausgestaltungen und Weiterbildungen der Erfindung angegeben.

Die erfindungsgemäße Schaltvorrichtung umfasst im Wesentlichen eine Antenne und eine Meßbrücke, die aus zwei parallel geschalteten Spannungsteilern besteht. Die Antenne wird mittels einer Anpaßschaltung auf einen vorgegebenen Widerstand angepaßt und der Widerstand wirkt in einem der Spannungsteiler. Ändert sich der Widerstand, wird ein Schaltsignal erzeugt. Wird die erfindungsgemäße Schaltvorrichtung beispielsweise in einem Lesegerät zur Kommunikation mit einem Transponder eingesetzt, dann ändert sich der Widerstand der Anpaßschaltung, sobald ein Transponder in den Erfassungsbereich des Lesegeräts gelangt. Ist die Antenne beispielsweise eine Antennenspule, die ein elektromagnetisches Wechselfeld erzeugt, so wird durch eine magnetische Gegenkopplung zwischen der Antennenspule des Lesegeräts und der Antennenspule des Transponders eine zusätzliche Impedanz in die Antennenspule transformiert. Dadurch ändert sich auch der mittels der Anpaßschaltung angepaßte Widerstand, der auf einen der Spannungsteiler wirkt. Diese Änderung wird durch die Meßbrücke erkannt und führt zu einem Steuersignal, welches beispielsweise das Lesegerät zur Kommunikation mit dem Transponder aktiviert. Die Kommunikation zwischen dem Lesegerät und dem Transponder erfolgt dann in bekannter Weise.

Vorzugsweise umfaßt jeder Spannungsteiler der Meßbrücke zwei in Reihe geschaltete Widerstände, wobei sich die Meßbrücke dann besonders bevorzugt als Wheatstonesche Brückenschaltung realisieren läßt.

Die für die Erkennung eines Transponders im Erkennungsbereich einer Lesevorrichtung benötigte Schaltung kann nahezu leistungslos betrieben werden, da die erfindungsgemäße Schaltvorrichtung keine periodischen Abfragesignale hoher Feldstärke aussenden muss, um einen Transponder zu erkennen. Entsprechend weist die Schaltvorrichtung einen außerordentlich geringen Energieverbrauch auf. Sie eignet sich deshalb in besonderer Weise zur Betätigung von Schaltkreisen, deren Energieversorgung aus einer begrenzten Energiequelle erfolgt. Insbesondere eignet sie sich daher zur Versorgung von aus kleinen Batterien, Solarzellen, Brennstoffelementen und ähnlichen Energiequellen gespeisten Schaltkreisen. Die weitgehende Unabhängigkeit von der Größe der zur Verfügung stehenden Energiequelle erlaubt eine freizügige Verwendung der Vorrichtung an einer Vielzahl von sonst nicht in Betracht kommenden Einbauorten.

Das erfindungsgemäße Lesegerät ist desweiteren sehr benutzerfreundlich, da es von einem Benutzer keinerlei besondere Handhabungsmaßnahmen erfordert. Die eingesetzten Transponder können die übliche Erscheinungsform haben und auf übliche Weise genutzt werden. Insbesondere sind keine besonderen konstruktiven Maßnahmen in Bezug auf den Aufbau des Transponders erforderlich. Ein besonderer Vorteil des erfindungsgemäßen Lesegeräts besteht somit darin, daß transponderseitig die ohnehin vorhandene Spule des Transponders den Schaltvorgang auslöst, besondere Bauelemente somit nicht erforderlich sind. Die Transponder können entsprechend kostengünstig ausgeführt werden.

Ein weiterer Vorteil der Erfindung ist, daß die Anpaßschaltung eingerichtet sein kann, die Antenne auf einen Widerstand von z.B. 50 Ω anzupassen, also an die für Transponder-Lesegeräte typische Impedanz von 50 Ω. Daher kann die Meßbrücke über eine koaxiale Leitungsverbindung getrennt von der Antennenspule bzw. dem Lesegerät angeordnet sein. Desweiteren ist eine nachträgliche Realisierung der erfindungsgemäßen Schaltvorrichtung in bestehenden Lesegeräten problemlos möglich.

Weitere Merkmale und Vorteile der Erfindung ergeben sich aus der folgenden Beschreibung verschiedener, erfindungsgemäßer Ausführungsbeispiele und Ausführungsalternativen im Zusammenhang mit den begleitenden Zeichnungen. Darin zeigen:

Figur 1    das Prinzipschaltbild der aus dem Stand der Technik bekannten Wheatstoneschen Meßbrücke;

Figur 2    den prinzipiellen Aufbau einer erfindungsgemäßen Schaltvorrichtung; und

Figur 3    den Aufbau einer Vorrichtung zur nachträglichen Ausrüstung eines Lesegeräts mit der erfindungsgemäßen Schaltvorrichtung.

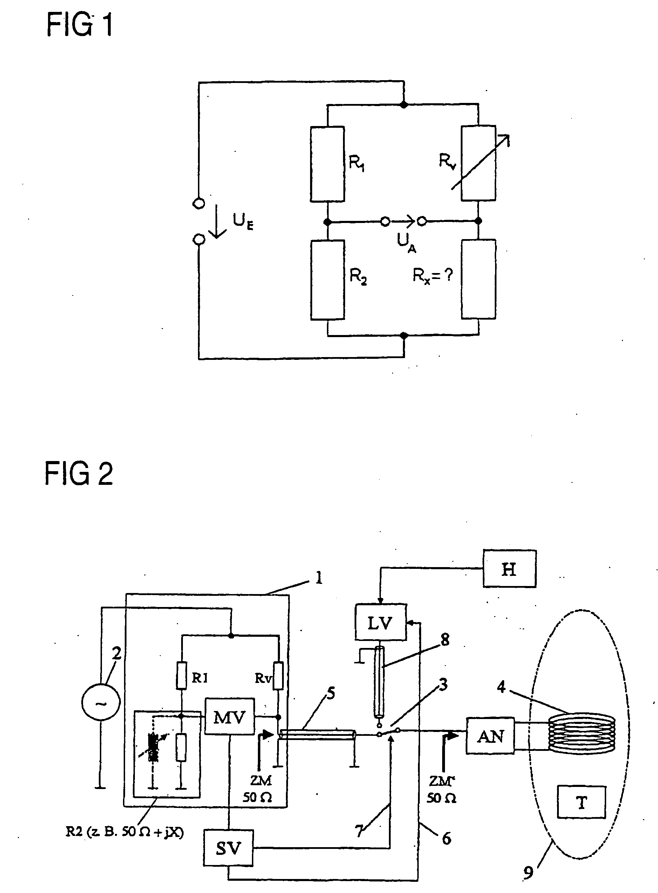

Figur 1 zeigt die aus dem Stand der Technik bekannte Wheatstonesche Meßbrücke. Eine Wheatstonesche Meßbrücke ist eine Parallelschaltung zweier Spannungsteiler, ihr Aufbau ist bekannt. Die Meßbrücke ist abgeglichen, wenn in der Brückendiagonale kein Strom fließt - bei einer Realisierung mit vier Widerständen also dann, wenn das Widerstandsverhältnis in beiden Spannungsteilern gleich ist. Mit Hilfe einer abgeglichenen Meßbrücke kann man einen unbekannten Widerstand bestimmen. Dazu muß man einen Spannungsteiler durch ein Potentiometer ersetzen und die folgende Abgleichbedingung benutzen:

$$R1/R2 = Rv/Rx \text{ oder } U1/U2 = Uv/Ux.$$

Die Eingangsspannung UE und die Ausgangsspannung UA werden jeweils an gegenüberliegenden Verbindungspunkten angelegt bzw. abgegriffen. Die Widerstände R1 und R2 sind bekannt, und Rv ist ein variabler, bekannter Vergleichswiderstand. Rx ist der unbekannte, zu bestimmende Widerstand. Rv wird nun so eingestellt bzw. gewählt, daß über die Brücke kein Strom fließt - also an UA keine Spannung abgegriffen wird; dieser Vorgang heißt auch Nullabgleich. Die Wheatstonesche Meßbrücke wird vor allem in der Meßtechnik sowie in der Steuerungs- und Regelungstechnik (Sensortechnik) für Präzisionsmessungen verwendet. Statt reiner Widerstände werden in der Wechselstromtechnik oft Impedanzen eingesetzt, um Wirkwiderstand und Blindwiderstand gleichzeitig abzugleichen. Je nach Anzahl der variablen Widerstände unterscheidet man dann Viertelbrücke (eine variable Impedanz), Halbbrücke (zwei variable Impedanzen) und Vollbrücke (vier variable Impedanzen).

Figur 2 zeigt ein Ausführungsbeispiel einer erfindungsgemäßen Auswerteeinrichtung. Die Auswerteeinrichtung besteht aus einer Wheatstoneschen Meßbrücke 1, einem HF-Oszillator 2, einem Meßverstärker MV, einer Steuervorrichtung SV, einer Antennen-Anpaßschaltung AN für eine Leseantenne 4, sowie einer RFID-Lesevorrichtung LV. Die Lesevorrichtung LV kann desweiteren mit einem Hostrechner H verbunden sein.

Der HF-Oszillator 2 erzeugt eine sinusförmige Wechselspannung mit einer Frequenz entsprechend der Sendefrequenz der Lesevorrichtung LV, z.B. 13,56 MHz, welche in der Meßbrücke 1 eingespeist wird. Die Meßbrücke 1 besteht aus den beiden Spannungsteilern R1/R2 und Rv/ZM.

Die Leseantenne 4 besteht üblicherweise aus einer Leiterschleife mit wenigstens einer Windung. Mit Hilfe der Anpaßschaltung AN wird die Leiterschleife auf der Sendefrequenz des Lesegeräts in Resonanz gebracht (Schwingkreis) und gleichzeitig die Impedanz der Antenne auf einen reellen Widerstand von 50 $\Omega$ am Eingang der Anpaßschaltung transformiert. Der Eingang der Anpaßschaltung AN wird über einen Schalter 3 sowie gegebenenfalls eine Koaxialverbindung 5 an die Meßbrücke 1 angeschlossen. In der Meßbrücke 1 ist die an der Koaxialverbindung sichtbare Eingangsimpedanz ZM, in der Regel die Eingangsimpedanz der Anpaßschaltung AN (also 50 $\Omega$), wirksamer Bestandteil des Spannungsteilers Rv/ZM. Bei einer entsprechenden räumlichen Nähe zwischen dem Schalter 3 und der Meßbrücke 1 kann die Koaxialkabelverbindung 5 gegebenenfalls entfallen. Auch in diesem Fall entspricht die Impedanz ZM der Eingangsimpedanz der Anpaßschaltung AN.

Die Brücke wird so abgeglichen, daß die Bedingung R1/R2 = Rv/ZM erfüllt ist, d.h. in der Regel gilt: R1/R2 = Rv/50 $\Omega$. Für diesen Fall wird die Spannung UA zwischen den beiden Spannungsteilern zu Null.

Gelangt ein Transponder T in den Ansprechbereich 9 der Antenne 4, so wird durch eine magnetische Gegenkopplung zwischen der Antennenspule 4 und der Antennenspule des Transponders T eine zusätzliche Impedanz in die Antennenspule 4 transformiert. Dies führt dazu, daß sich auch die Impedanz ZM' am Ausgang der Anpaßschaltung AN verändert, also nicht mehr reellen 50 $\Omega$ entspricht, sondern einen beliebigen Wert R $\pm$ jX, annehmen kann. Auch am Ende des Koaxialkabels 5 ist der veränderte Wert der Impedanz ZM messbar. Dies führt dazu, daß die Bedingung R1/R2 = Rv/ZM nicht mehr erfüllt ist und die Spannung UA zwischen den beiden Spannungsteilern ungleich Null wird. Durch den Meßverstärker MV wird diese Spannung verstärkt und der Steuervorrichtung SV in Form eines Steuersignals zugeführt. Beim Überschreiten einer definierten Schwelle, wenn also ein Steuersignal von der Meßbrücke 1 an die Steuervorrichtung SV gesendet wird, geht die Steuervorrichtung SV davon aus, daß sich nun ein Transponder im Ansprechbereich 9 der Antennenspule 4 befindet.

Zur Einleitung einer Kommunikation mit dem Transponder T wird dann in einem ersten Schritt die Anpaßschaltung AN über den Schalter 3 mit der Lesevorrichtung LV verbunden. Der Schalter 3 wird hierzu mit einem Schaltsignal 7 durch die Steuervorrichtung SV betätigt. In einem zweiten Schritt sendet die Steuervorrichtung SV der Lesevorrichtung LV ein Startsignal, worauf diese den Sender anschaltet und eine Kommunikationsverbindung mit dem Transponder herstellt.

Verlässt der Transponder T den Ansprechbereich der Antenne 4, so kann vorgesehen sein, daß die Lesevorrichtung LV der Steuervorrichtung SV signalisiert, daß kein Transponder mehr angesprochen werden kann. Die Steuervorrichtung SV schaltet daraufhin die Anpaßschaltung AN über den Schalter 3 wieder an die Meßbrücke 1, welche sich nun wieder im abgeglichenen Zustand befindet, das heißt die Bedingung R1/R2 = Rv/50$\Omega$ ist wieder erfüllt. Gleichzeitig wird der Sender der Lesevorrichtung LV wieder abgeschaltet, um nicht unnötig Energie zu verbrauchen.

In der Praxis kann die Antenne 4 durch die Anpaßschaltung AN nicht immer exakt auf reelle 50 $\Omega$ angepasst werden. Häufig verbleibt ein geringer komplexer Widerstand jX. Durch das Hinzufügen eines komplexen Widerstands $jX_2$ an wenigstens einem der Widerstände R1, R2 oder Rv kann der abgeglichene Zustand jedoch wieder hergestellt werden. In Figur ist beispielhaft dargestellt, daß der Widerstand R2 dimensioniert ist als: R2 = 50 $\Omega$ $\pm$ jX.

Selbstverständlich kann das Funktionsprinzip der erfindungsgemäße Anordnung auch bei anderen Antenneneingangswiderständen als 50 $\Omega$ angewandt werden. Die Meßbrücke ist dann jeweils angepaßt zu dimensionieren, so daß die Abgleichsbedingung R1/R2= Rv/ZM erfüllt wird.

Zur einfacheren Integration in ein Transponder-Lesegerät oder zur nachträglichen Ausrüstung eines Transponder-Lesegerätes mit der erfindungsgemä-βen Anordnung sind Meßbrücke 1, HF-Oszillator 2 und Steuervorrichtung SV zweckmäßigerweise in einer integrierten Detektions-Baueinheit untergebracht. Eine solche Detektions-Baueinheit besitzt dann einen Eingang für eine Spannungsversorgung, die auch die Lesevorrichtung LV versorgt. Weiter besitzt sie einen HF-Wechselspannungsausgang zum Anschluß an den Schalter 3 bzw. die Leseantenne 4, einen mit der Lesevorrichtung LV und dem Schalter 3 verbundenen Schaltausgang zum Ein- und Ausschalten der beiden, sowie einen Rücksetzeingang zum Empfang eines Rücksetzsignales von der Lesevorrichtung LV nach dem Wieder-Entfernen eines Transponders aus dem Ansprechbereich 9.

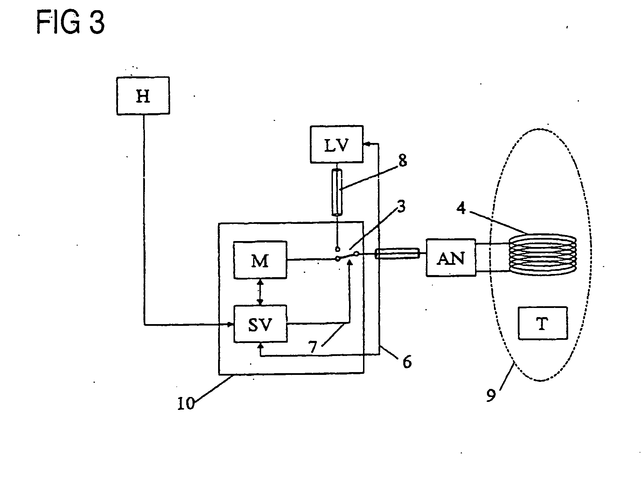

Figur 3 zeigt eine Vorrichtung 10 zum nachträglichen Ausrüsten eines Lesegeräts mit der erfindungsgemäßen leistungslosen Transpondererkennungsschaltung. Die Steuervorrichtung SV wird bei der in Figur 3 dargestellten Ausführungsform mit Softwaremitteln zur Kommunikation mit einem Host H, sowie zur Ansteuerung des nachträglich auszurüstenden Lesegeräts ausgestattet. Desweiteren wird die direkte Kommunikation zwischen der Lesevorrichtung LV und dem Host H unterbrochen und stattdessen über die Steuervorrichtung SV geleitet und kontrolliert. In die Antennenverbindung 8 zwischen der Lesevorrichtung LV und der Anpaßschaltung AN wird darüberhinaus der Schalter 3 der Vorrichtung 10 eingefügt.

Es ist vorgesehen, daß der Host H zunächst mit der Steuervorrichtung V kommuniziert. Solange die erfindungsgemäße Messeinrichtung M keinen Transponder T erkennt, meldet die Steuervorrichtung SV den Status "kein Transponder im Feld" an den Host H zurück.

Gelangt ein Transponder T in den Ansprechbereich 9 der Antenne 4 und wird dieser von der Messeinrichtung M erkannt, so ist vorgesehen, daß die Steuervorrichtung SV die Lesevorrichtung LV über die Kommunikationsverbindung 6 aktiviert. Kennt die Lesevorrichtung LV kein explizites Kommando zum Ein- und Ausschalten ihres Senders, oder hat die Lesevorrichtung auch im Standbybetrieb eine zu hohe Stromaufnahme, kann auch das Ein- und Ausschalten der Spannungsversorgung der Lesevorrichtung LV vorgesehen sein. Weiterhin wird die Anpaßschaltung AN über den Schalter 3 mit dem Antennenanschluß 8 der Lesevorrichtung verbunden.

Meldet die Lesevorrichtung den erfolgreichen Aufbau einer Kommunikationsbeziehung mit dem Transponder T, so ist vorgesehen, diesen Status an den Host H weiterzumelden. Im weiteren Ablauf können gegebenenfalls eingehende Kommandos des Hosts und die Antworten der Lesevorrichtung LV von der Steuervorrichtung SV ohne weitere Bearbeitung zwischen Host und Lesevorrichtung durchgereicht werden, so daß Host und Lesevorrichtung LV ungestört miteinander kommunizieren können (transparenter Modus der Steuervorrichtung SV). Es ist lediglich vorgesehen, daß die Steuervorrichtung SV die Kommunikation zwischen dem Host H und der Lesevorrichtung LV überwacht, um so den Status "Transponder hat Ansprechfeld verlassen" erkennen zu können.

Hat der Transponder das Ansprechfeld verlassen, ist erfindungsgemäß vorgesehen, daß die Lesevorrichtung LV durch ein Kommando der Steuervorrichtung SV oder gegebenenfalls durch das Abschalten der Spannungsversorgung wieder deaktiviert wird. Danach übernimmt die Steuervorrichtung SV wieder die Kommunikation mit dem Host H und schaltet schließlich die Anpaßschaltung AN mittels des Schalters 3 auf die Messeinrichtung M, um den Messvorgang wieder aufzunehmen.

In einer Variante zu den beiden in den Fig. 2 und 3 dargestellten Ausführungen ist vorgesehen, daß die Lesevorrichtung LV nach Detektion eines Transponders jeweils genau für eine voreingestellte Zeit von der Steuervorrichtung SV aktiviert wird. Die Steuervorrichtung oder auch die Lesevorrichtung LV selbst verfügt hierzu über ein entsprechendes Timer-Modul. Nach Ablauf der an dem Timer-Modul voreingestellten Zeit wird der Schalter 3 wieder an die Meßvorrichtung MV verbunden; zugleich wird die Energieversorgung der Lesevorrichtung LV unterbrochen. Die Variante eignet sich besonders für Anordnungen, die über keinen geeigneten Standby- oder Selbstabschaltungsmechanismus verfügen oder in denen ein solcher Modus von außen nicht eingestellt werden kann.

**Patentansprüche**

1. Schaltvorrichtung mit einer Antenne zur Erzeugung eines Schaltsignals zur Herstellung einer Kommunikation mit einem Transponder, das durch Einbringen des Transponders in den Ansprechbereich der Antenne aktivierbar ist, **dadurch gekennzeichnet**, daß die Antenne (4) mittels einer Anpaßschaltung (AN) auf einen vorgegebenen Widerstand (ZM) angepasst ist, und der Widerstand (ZM) Teil einer Meßbrücke (1) ist, die aus zwei parallel geschalteten Spannungsteilern besteht, wobei der Widerstand (ZM) in einem der Spannungsteiler wirkt und die Meßbrücke (1) eine Änderung des Widerstands (ZM) erkennt und bei einer Änderung des Widerstands (ZM) das Schaltsignal erzeugt.

2. Schaltvorrichtung nach Anspruch 1, **dadurch gekennzeichnet, daß** jeder Spannungsteiler zwei in Reihe geschaltete Widerstände besitzt.

**3.** Schaltvorrichtung nach Anspruch 1 oder 2, **dadurch gekennzeichnet, daß** die Meßbrücke (1) eine Wheatstonesche Meßbrücke ist.

**4.** Schaltvorrichtung nach einem der Ansprüche 1 bis 3, **dadurch gekennzeichnet, daß** die Meßbrücke (1) dazu eingerichtet ist das Schaltsignal zu erzeugen, wenn eine Spannung (UA) zwischen den zwei parallel geschalteten Spannungsteilern eine vorgegebene Schwelle überschreitet.

**5.** Schaltvorrichtung nach einem der Ansprüche 1 bis 4, **dadurch gekennzeichnet, daß** die Anpaßschaltung (AN) eingerichtet ist, die Antenne (4) auf einer zur Kommunikation mit anderen Geräten geeigneten Frequenz in Resonanz zu bringen.

**6.** Schaltvorrichtung nach einem der Ansprüche 1 bis 5, **dadurch gekennzeichnet, daß** die Anpaßschaltung (AN) eingerichtet ist, die Antenne auf einen vorgegebenen Widerstand von z.B. 50 Ω anzupassen.

**7.** Schaltvorrichtung nach einem der Ansprüche 1 bis 6, **dadurch gekennzeichnet, daß** die Anpaßschaltung (AN) über eine Koaxialkabelverbindung (5) mit der Meßbrücke (1) verbunden ist.

**8.** Schaltvorrichtung nach einem der Ansprüche 1 bis 7, **dadurch gekennzeichnet, daß** die Antenne (4) eine Antennenspule ist.

**9.** Schaltvorrichtung nach einem der Ansprüche 1 bis 8, **gekennzeichnet durch** einen HF-Oszillator (2), der eine Wechselspannung mit einer vorbestimmten Frequenz erzeugt und in die Meßbrücke (1) einspeist.

**10.** Schaltvorrichtung nach einem der Ansprüche 1 bis 9, **gekennzeichnet durch** einen Meßverstärker (MV), der zwischen den beiden Spannungsteilern angeordnet ist.

**11.** Schaltvorrichtung nach einem der Ansprüche 1 bis 10, **dadurch gekennzeichnet, daß** die Schaltvorrichtung eingerichtet ist, in einer Transponder-Lesevorrichtung zur Kommunikation mit einem Transponder verwendet zu werden.

**12.** Lesegerät zum Kommunizieren mit einem Transponder eines externen Geräts, umfassend eine Lesevorrichtung (LV), die die Kommunikation mit dem Transponder durchführt, eine Schaltvorrichtung nach einem der Ansprüche 1 bis 11 und eine Steuervorrichtung (SV), die eingerichtet ist, aufgrund eines Schaltsignals der Schaltvorrichtung einen Schalter (3) zu steuern, der die Anpaßschaltung (AN) mit der Lesevorrichtung (LV) verbindet.

**13.** Lesegerät nach Anspruch 12, **dadurch gekennzeichnet, daß** die Steuervorrichtung (SV) eingerichtet ist, den Schalter (3) sowohl abhängig von dem Schaltsignal der Schaltvorrichtung als auch von einem Signal der Lesevorrichtung (LV) zu steuern.

**14.** Lesegerät nach Anspruch 12 oder 13, **dadurch gekennzeichnet, daß** die Lesevorrichtung (LV) eingerichtet ist, die Kommunikation mit dem Transponder des externen Geräts zu starten, wenn die Steuervorrichtung (SV) das Schaltsignal von der Schaltvorrichtung empfängt.

**15.** Verfahren zur Kommunikation zwischen einem Lesegerät und einem Transponder (T) eines externen Geräts, wobei das Lesegerät eine Lesevorrichtung (LV) zur Kommunikation mit dem Transponder (T) und eine Steuervorrichtung (SV) umfasst, und wobei eine Schaltvorrichtung ein Schaltsignal für die Steuervorrichtung (SV) erzeugt, wenn ein Transponder in einen Erfassungsbereich der Antenne (4) der Schaltvorrichtung gelangt, und die Steuervorrichtung aufgrund des Schaltsignals die Kommunikation mit dem Transponder des externen Geräts aktiviert, **dadurch gekennzeichnet, daß** als Schaltvorrichtung eine Schaltvorrichtung nach einem der Ansprüche 1 bis 11 verwendet wird.

**16.** Verfahren nach Anspruch 15, **dadurch gekennzeichnet, daß** die Meßbrücke (1) der Schaltvorrichtung mit der Anpaßschaltung (AN) der Schaltvorrichtung über einen Schalter (3) verbunden wird, wenn keine Kommunikation der Lesevorrichtung (LV) mit einem Transponder (T) stattfindet.

**17.** Verfahren nach Anspruch 15, **dadurch gekennzeichnet, daß** die Lesevorrichtung (LV) mit der Anpaßschaltung (AN) der Schaltvorrichtung über einen Schalter (3) verbunden wird, wenn die Schaltvorrichtung ein Schaltsignal liefert.

**Claims**

1. A switching device with an antenna for generating a switch signal for setting up a communication with a transponder, which switch signal is activatable by bringing the transponder in the response range of the antenna, **characterized in that** the antenna (4) is adapted to a given resistance (ZM) with the help of an adapter circuit (AN), and the resistance (ZM) is part of a measuring bridge (1) which consists of two voltage dividers connected in parallel, wherein the resistance (ZM) acts in one of the voltage dividers and the measuring bridge (1) recognizes a change of the resistance (ZM) and upon a change of the resistance (ZM) generates the switch signal.

2. The switching device according to claim 1, **characterized in that** each voltage divider has two resistors connected in series.

3. The switching device according to claim 1 or 2, **characterized in that** the measuring bridge (1) is a Wheatstone measuring bridge.

4. The switching device according to any of claims 1 to 3, **characterized in that** the measuring bridge (1) is designed to generate the switch signal, when a voltage (UA) between the two voltage dividers connected in parallel exceeds a given threshold.

5. The switching device according to any of claims 1 to 4, **characterized in that** the adapter circuit (AN) is designed to resonate the antenna (4) at a frequency suitable for the communication with other devices.

6. The switching device according to any of claims 1 to 5, **characterized in that** the adapter circuit (AN) is designed to adapt the antenna to a given resistance of e.g. 50 Ω.

7. The switching device according to any of claims 1 to 6, **characterized in that** the adapter circuit (AN) via a coaxial cable connection (5) is connected with the measuring bridge (1).

8. The switching device according to any of claims 1 to 7, **characterized in that** the antenna (4) is an antenna coil.

9. The switching device according to any of claims 1 to 8, **characterized by** a high-frequency oscillator (2), which generates an alternating voltage with a predetermined frequency and feeds it into the measuring bridge (1).

10. The switching device according to any of claims 1 to 9, **characterized by** a measuring amplifier (MV), which is disposed between the two voltage dividers.

11. The switching device according to any of claims 1 to 10, **characterized in that** the switching device is designed to be used in a transponder reading device for the communication with a transponder.

12. A reading device for communicating with a transponder of an external device, comprising a reading apparatus (LV), which carries out the communication with the transponder, a switching device according to any of claims 1 to 11 and a control device (SV), which is designed to control a switch (3) on the basis of a switch signal of the switching device, the switch (3) connecting the adapter circuit (AN) with the reading device (LV) .

13. The reading device according to claim 12, **characterized in that** the control device (SV) is designed to control the switch (3) both dependent on the switch signal of the switching device and dependent on a signal of the reading apparatus (LV).

14. The reading device according to claim 12 or 13, **characterized in that** the reading apparatus (LV) is designed to start the communication with the transponder of the external device, when the control device (SV) receives the switch signal from the switching device.

15. A method for the communication between a reading device and a transponder (T) of an external device, wherein the reading device comprises a reading apparatus (LV) for the communication with the transponder (T) and a control device (SV), and wherein a switching device generates a switch signal for the control device (SV), when a transponder reaches a detection range of the antenna (4) of the switching device, and the control device on the basis of the switch signal activates the communication with the transponder of the external device, **characterized in that** as a switching device a switching device according to any of claims 1 to 11 is used.

**16.** The method according to claim 15, **characterized in that** the measuring bridge (1) of the switching device is connected with the adapter circuit (AN) of the switching device via a switch (3), when no communication of the reading apparatus (LV) with a transponder (T) takes place.

**17.** The method according to claim 15, **characterized in that** the reading apparatus (LV) is connected with the adapter circuit (AN) of the switching device via a switch (3), when the switching device supplies a switch signal.

**Revendications**

**1.** Dispositif de commutation avec une antenne pour la génération d'un signal de commutation destiné à établir une communication avec un transpondeur et activable par inclusion du transpondeur dans la zone de saisie de l'antenne, **caractérisé en ce que** l'antenne (4) est ajustée à une résistance (ZM) déterminée au moyen d'un circuit adaptateur (AN), et **en ce que** la résistance (ZM) fait partie d'un pont de mesure (1) constitué de deux diviseurs de tension montés en parallèle, ladite résistance (ZM) étant fonctionnelle dans un des diviseurs de tension, et le pont de mesure (1) détectant une variation de la résistance (ZM) et générant le signal de commutation en cas de variation de la résistance (ZM).

**2.** Dispositif de commutation selon la revendication 1, **caractérisé en ce que** chaque diviseur de tension est pourvu de deux résistances montées en série.

**3.** Dispositif de commutation selon la revendication 1 ou la revendication 2, **caractérisé en ce que** le pont de mesure (1) est un pont Wheatstone.

**4.** Dispositif de commutation selon l'une des revendications 1 à 3, **caractérisé en ce que** le pont de mesure (1) est prévu pour générer le signal de commutation si une tension (UA) entre les deux diviseurs de tension monté en parallèle dépasse un seuil défini.

**5.** Dispositif de commutation selon l'une des revendications 1 à 4, **caractérisé en ce que** le circuit adaptateur (AN) est prévu pour mettre en résonance l'antenne (4) sur une fréquence appropriée à la communication avec d'autres appareils.

**6.** Dispositif de commutation selon l'une des revendications 1 à 5, **caractérisé en ce que** le circuit adaptateur (AN) est prévu pour ajuster l'antenne à une résistance déterminée de quelque 50 Ω.

**7.** Dispositif de commutation selon l'une des revendications 1 à 6, **caractérisé en ce que** le circuit adaptateur (AN) est relié au pont de mesure (1) par une liaison à câble coaxial (5).

**8.** Dispositif de commutation selon l'une des revendications 1 à 7, **caractérisé en ce que** l'antenne (4) est une bobine d'antenne.

**9.** Dispositif de commutation selon l'une des revendications 1 à 8, **caractérisé par** un oscillateur HF (2), lequel génère une tension alternative avec une fréquence déterminée et applique celle-ci sur le pont de mesure (1).

**10.** Dispositif de commutation selon l'une des revendications 1 à 9, **caractérisé par** un amplificateur de mesure (MV) disposé entre les deux diviseurs de tension.

**11.** Dispositif de commutation selon l'une des revendications 1 à 10, **caractérisé en ce que** le dispositif de commutation est prévu pour être utilisé dans un dispositif de lecture de transpondeur permettant la communication avec un transpondeur.

**12.** Appareil de lecture permettant la communication avec un transpondeur d'un appareil externe, comprenant un dispositif de lecture (LV) établissant la communication avec le transpondeur, un dispositif de commutation selon l'une des revendications 1 à 11 et un dispositif de commande (SV) prévu pour commander un commutateur (3) sur la base d'un signal de commutation du dispositif de commutation, lequel relie le circuit adaptateur (AN) au dispositif de lecture (LV).

**13.** Appareil de lecture selon la revendication 12, **caractérisé en ce que** le dispositif de commande (SV) est prévu pour commander le commutateur (3) en fonction tant du signal de commutation du dispositif de commutation que d'un signal du dispositif de lecture (LV).

14. Appareil de lecture selon la revendication 12 ou la revendication 13, **caractérisé en ce que** le dispositif de lecture (LV) est prévu pour lancer la communication avec le transpondeur de l'appareil externe quand le dispositif de commande (SV) reçoit le signal de commutation du dispositif de commutation.

15. Procédé de communication entre un appareil de lecture et un transpondeur (T) d'un appareil externe, où l'appareil de lecture comprend un dispositif de lecture (LV) permettant la communication avec le transpondeur (T) et un dispositif de commande (SV), et où un dispositif de commutation génère un signal de commutation pour le dispositif de commande (SV) quand un transpondeur parvient dans une zone de saisie de l'antenne (4) du dispositif de commutation, et où le dispositif de commande active la communication avec le transpondeur de l'appareil externe sur la base du signal de commutation, **caractérisé en ce qu'**un dispositif de commutation selon l'une des revendications 1 à 11 est utilisé comme dispositif de commutation.

16. Procédé selon la revendication 15, **caractérisé en ce que** le pont de mesure (1) du dispositif de commutation est relié au circuit adaptateur (AN) du dispositif de commutation via un commutateur (3) lorsque aucune communication du dispositif de lecture (LV) n'est établie avec un transpondeur (T).

17. Procédé selon la revendication 15, **caractérisé en ce que** le dispositif de lecture (LV) est relié au circuit adaptateur (AN) du dispositif de
commutation via un commutateur (3) lorsque le dispositif de commutation émet un signal de commutation.

## FIG 1

## FIG 2

FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6150948 A
- WO 03069538 A1
- WO 2005013506 A1
- WO 2005013506 A
- US 4546241 A
- EP 1538558 A2